# EUROPÄISCHE PATENTSCHRIFT

(11) **EP 1 315 264 B1**
(45) Veröffentlichungstag und Bekanntmachung des Hinweises auf die Patenterteilung: **06.11.2013**
(21) Anmeldenummer: 02017833.1
(22) Anmeldetag: 08.08.2002
(51) Int. Cl.: H02M 5/458, G01R 31/02, H02M 1/32, H02H 11/00, H02H 7/12

(54) **Verfahren zur Erdschlussüberwachung eines Stromrichterantriebs**
Method for earth fault monitoring of a power converter drive
Procédé pour la surveillance contre les défauts à la terre d'un convertisseur de puissance

(30) Priorität: 27.09.2001 DE 10148740
(43) Veröffentlichungstag der Anmeldung: 28.05.2003
(73) Patentinhaber: Dr. Johannes Heidenhain GmbH, 83292 Traunreut (DE)
(72) Erfinder: Huber, Norbert, 83317 Teisendorf (DE); Ritz, Franz, 83236 Übersee (DE)

(56) Entgegenhaltungen:
- EP-A- 1 122 849
- WO-A-01/06272
- US-A- 4 253 056

## Beschreibung

Die Erfindung bezieht sich auf ein Verfahren zur Erdschlussüberwachung eines Stromrichterantriebs.

Aus der WO 01/06272 A1 ist ein Verfahren für einen Umrichter bekannt, mit dem vor dem eigentlichen Betrieb des Umrichters ein Test auf Kurzschlüsse in den Halbleiterschaltern des Umrichters durchgeführt werden kann. Hierzu wird versucht, den Zwischenkreis des Umrichters mit einer Ladeschaltung zu laden. Ein Erdschluss im angeschlossenen Motor kann so aber nicht detektiert werden.

Aus der US-A-4 253 056 ist ein Erdschlussdetektor bekannt, der aus einer parallel zu einer Last und einer Gleichspannungsquelle geschalteten Erkennungsschaltung besteht. Die Erkennungsschaltung weist zwei Spannungsteiler mit jeweils zwei in Reihe geschalteten Widerständen auf, deren Verbindung jeweils an einen Eingang eines Spannungskomparators angeschlossen ist. Die Komparatoreingänge sind außerdem über jeweils eine Diode, die in einander entgegengesetzter Durchlassrichtung gepolt sind, mit Masse- oder Erdpotential verbunden. Ein im Gleichspannungskreis auftretender Erdschluss verändert die Polarität an den Komparatoreingängen und ruft ein Ausgangssignal des Spannungskomparators zur Anzeige des Erdschlusses hervor.

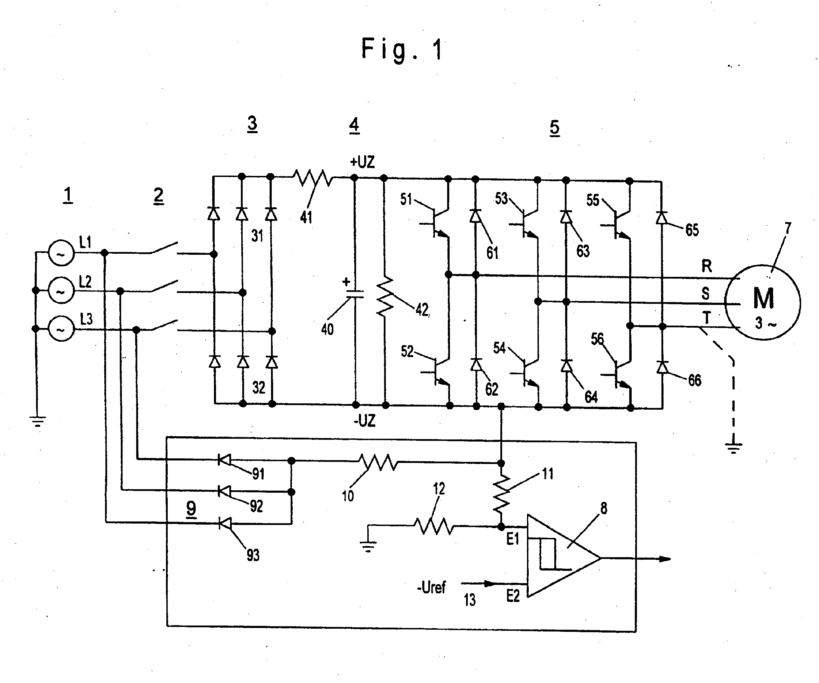

Der bekannte Erdschlussdetektor zeigt jedoch einen Erdschluss im Lastkreis nur bei einer bereits an die Gleichspannungsquelle angeschlossenen Last an, das heißt im laufenden Betrieb und nicht vor dem Anschluss der Last an die Speisespannungsquelle. Liegt ein Erdschluss aber bereits vor dem Verbinden der Last mit der Speisespannungsquelle vor, so kann dies bereits infolge hoher Fehlerströme zu einer Zerstörung von Bauteilen, insbesondere zur Zerstörung elektronischer Bauteile zur Ansteuerung von Halbleiter-Leistungsschaltern führen. Dies soll anhand eines in Figur 1 dargestellten Zwischenkreisumrichters zur Speisung eines Drehstrommotors aus einem Drehstromnetz erläutert werden.

Der in Figur 1 dargestellte, dreiphasige Zwischenkreisumrichter 3, 4, 5 setzt sich aus einem Ladegleichrichter 3 mit in Drehstrom-Brückenschaltung angeordneten Ladedioden 31, 32, einem Gleichstrom-Zwischenkreis 4 mit einem Ladewiderstand oder einer konstanten Stromquelle 41, einem Zwischenkreiskondensator 40 und einem parallel zum Zwischenkreiskondensator 40 angeordneten Zwischenkreiswiderstand 42, sowie einem Halbleiter-Leistungsschalter 5 mit ebenfalls in Drehstrom-Brückenschaltung angeordneten, als IGBT ausgebildeten Halbleiterschaltern 51 bis 56 zusammen, parallel zu deren Lastanschlüsse Freilaufdioden 61 bis 66 geschaltet sind, die antiparallel zur Durchlassrichtung der Halbleiterschalter 51 bis 56 gepolt sind. Eingangsseitig ist der Zwischenkreisumrichter 3, 4, 5 über ein Laderelais 2 an ein speisendes Drehstromnetz mit den Phasen L1, L2 und L3 angeschlossen und speist ausgangsseitig über die Phasen R, S und T einen Drehstrommotor 7.

Der Zwischenkreiskondensator 40 wird über den Ladewiderstand beziehungsweise die Konstantstromquelle 41 gespeist, glättet die Ausgangsspannung des Ladegleichrichters 3 und speichert die Zwischenkreisenergie. Dabei begrenzt der Ladewiderstand beziehungsweise die Konstantstromquelle 41 den Einschaltstrom, da der üblicherweise sehr große Zwischenkreiskondensator 40 im ungeladenen Zustand wie ein Kurzschluss wirkt, der einen hohen Einschaltstrom verursacht. Dieser würde zur einer Zerstörung von Bauelementen des Zwischenkreisumrichters, unter anderem des Laderelais 2, des Gleichrichters 3, des Zwischenkreiskondensators 40, einer oder mehrerer Freilaufdioden 61 bis 66, vorgeschalteter Sicherungen und/oder von Leiterbahnen der Schaltkreisplatine führen.

Die an die Steueranschlüsse der Halbleiter-Leistungsschalter 51 bis 56 angeschlossene Ansteuerelektronik bestimmt die Ansteuerfrequenz und über die Strom- und Spannungszeitflächen die ausgangsseitige Motorspannung beziehungsweise den Motorstrom, wobei die Ansteuerung der einzelnen Motorphasen R, S, T in Pulsweitenmodulation erfolgt. Dabei übernehmen die antiparallel zur Durchlassrichtung der Halbleiter-Leistungsschalter 51 bis 56 geschalteten Freilaufdioden 61 bis 66 den Stromfluss beim Abschalten des ihnen zugeordneten Halbleiter-Leistungsschalters 51 bis 56.

Bei dem in Figur 1 dargestellten Ausführungsbeispiel liegt bei geladenem Zwischenkreiskondensator 40 am negativen Anschluss -UZ des Zwischenkreiskondensators 40 beispielsweise eine Spannung von -280 V und am positiven Anschluss +UZ des Zwischenkreiskondensators 40 eine Spannung von +280 V gegenüber Masse- oder Erdpotential an. Werden die drei Phasenschalter des Laderelais 2 geschlossen und damit der Ladegleichrichter 3 an das speisende Drehstromnetz 1 angeschlossen, erzeugt der Ladegleichrichter 3 auf der Gleichspannungsseite eine Spannung von ca. 560 V, die komplett am Ladewiderstand 41 abfällt, da der Zwischenkreiskondensator 40 beim Einschalten noch ungeladen ist und dadurch als Kurzschluss wirkt. Der Ladewiderstand 41 begrenzt den Ladestrom kurz nach dem Einschalten des Laderelais 2 und beide Anschlüsse +UZ und -UZ des Zwischenkreiskondensators 40 liegen in diesem Einschaltaugenblick auf -280 V gegenüber Masse- oder Erdpotential. Mit zunehmender Aufladung des Zwischenkreiskondensators 40 steigt das Potential des positiven Anschlusses +UZ des Zwischenkreiskondensators 40 auf +280 V.

Tritt vor oder während des Einschaltvorgangs ein Erdschluss in einer Phase oder mehreren Phasen R, S, T auf bevor der Zwischenkreiskondensator 40 aufgeladen ist, ist der positive Anschluss +UZ des Zwischenkreiskondensators 40 um bis zu 280 V negativer als Masse- oder Erdpotential. Dadurch fließt beim Schließen des Laderelais 2 ein Kurzschlussstrom über eine der Freilaufdioden 57 bis 62, den Zwischenkreiskondensator 40 und eine Diode der beiden Diodenzweige 31, 32 des Ladegleichrichters 3, d.h. es fließt ein sehr hoher Kurzschlussstrom zwischen dem positiven Anschluss +UZ des Zwischenkreiskondensators 40 und Masse- oder Erdpotential, der den Zwischenkreiskondensator 40 schlagartig auflädt, so dass die zuvor beschriebene Gefahr der Zerstörung von Bauelementen des Zwischenkreisumrichters besteht.

Figur 1 zeigt in gestrichelten Linien einen Erdschluss der Phase T an, der beim Schließen des Laderelais 2 dazu führt, dass die Freilaufdiode 65 leitend wird, so dass ein Kurzschlussstrom über die Freilaufdiode 65, den Zwischenkreiskondensator 40 und die Ladedioden 32 des Ladegleichrichters3 fließt, was zu der vorstehend geschilderten Zerstörung der Ansteuerelektronik des Zwischenkreisumrichters führen kann.

Aufgabe der vorliegenden Erfindung ist es, ein Verfahren zur Erdschlussüberwachung eines Stromrichterantriebs der eingangs genannten Gattung anzugeben, das einen Erdschluss vor dem Verbinden des Stromrichters mit einer speisenden Spannungsquelle mit einfachen schaltungstechnischen Mitteln erfasst.

Diese Aufgabe wird erfindungsgemäß durch die Merkmale des Anspruchs 1 gelöst.

Das erfindungsgemäße Verfahren ermöglicht es, einen Erdschluss am Ausgang des Stromrichterantriebs mit einer einfachen elektrischen Schaltung im Voraus zu erkennen und ein entsprechendes Signal abzugeben, das den Erdschluss anzeigt bzw. ein Schließen eines Netzspannungsschalters blockiert.

Die erfindungsgemäße Lösung geht von der Erkenntnis aus, dass bereits vor dem Schließen der Schalteinrichtung, d.h. vor dem Verbinden des Stromrichters mit der Speisespannungsquelle, geprüft wird, ob das Potential des negativen Anschlusses des Lade- oder Zwischenkreiskondensators gegenüber Erdpotential verschoben werden kann. Ist eine Verschiebung des negativen Anschlusses des Lade- oder Zwischenkreiskondensators nicht möglich, so liegt ein Erdschluss in einer der Lastphasen vor, während bei intaktem Lastanschluss die dem Potential des negativen Anschlusses des Lade- oder Zwischenkreiskondensators überlagerte Prüfspannung zu einer entsprechenden Verschiebung des Potentials des negativen Anschlusses führt, so dass die Schalteinrichtung zur Verbindung des Stromrichters mit der Speisespannungsquelle freigegeben werden kann.

Eine vorteilhafte Ausgestaltung des erfindungsgemäßen Verfahrens sieht vor, das Potential des Kondensatoranschlusses nach dem Anlegen der Prüfspannung mit einem Referenzpotential zu vergleichen und bei einer vorgegebenen Abweichung des Potentials des Kondensatoranschlusses vom Referenzpotential die Schalteinrichtung zu sperren.

Erfindungsgemäß, in einem einen Zwischenkreisumrichter, der eingangsseitig über ein Laderelais mit einem speisenden Wechsel- oder Drehstromnetz und ausgangsseitig mit einem oder mehreren elektromotorischen Antrieb(en) verbunden ist, und in dessen Zwischenkreis ein Zwischenkreiskondensator und ein Ladewiderstand oder eine Konstantstromquelle angeordnet sind, wird der negative Anschluss des Zwischenkreiskondensators mit der Prüfspannung beaufschlagt, und bei einer vorgegebenen Veränderung des negativen Anschlusses des Zwischenkreiskondensators gegenüber Masse- oder Erdpotential wird die Schalteinrichtung freigegeben.

Auch bei dieser speziellen Anwendung des erfindungsgemäßen Verfahrens kann eine negative Prüfspannung an den negativen Anschluss des Zwischenkreiskondensators angelegt und mit einem Referenzpotential verglichen werden, so dass die Schalteinrichtung freigegeben wird, wenn das Potential des negativen Anschlusses des Zwischenkreiskondensators das Referenzpotential erreicht oder unterschreitet.

Alternativ kann eine positive Prüfspannung an den negativen Potentialanschluss des Zwischenkreiskondensators angelegt, mit einem Referenzpotential verglichen und die Schalteinrichtung freigegeben werden, wenn das Potential des negativen Potentialanschlusses des Zwischenkreiskondensators das Referenzpotential erreicht oder überschreitet.

Die negative oder positive Prüfspannung kann bei beiden Verfahrensvarianten dadurch gewonnen werden, dass die negativen oder positiven Halbwellen des speisenden Wechsel- oder Drehstromnetzes über einen hochohmigen Widerstand an dem negativen Anschluss des Zwischenkreiskondensatorsgelegt werden.

Die Auslöseeinrichtung kann aus einer Einrichtung zur Freigabe oder Sperrung der Schalteinrichtung und/oder einer Anzeigeeinrichtung bestehen, die mit dem Ausgang des Komparators verbunden sind. Um Fehlschaltungen zu verhindern und damit zu gewährleisten, dass keine Bauelemente des Zwischenkreisumrichters durch eine zu hohen Kurzschlussstrom beschädigt oder zerstört werden, ist der Freigabe oder Sperrung der Schalteinrichtung zum Anschluss des Stromrichters an die Speisespannungsquelle der Vorzug zu geben, wobei zusätzlich zur Freigabe oder Sperrung der Schalteinrichtung eine entsprechende Anzeige vorteilhaft ist, um dem Benutzer die Möglichkeit zur Fehlersuche und Fehlerbehebung zu geben. Die Anzeige selbst kann aus einem optischen oder akustischen Signal bzw. einer Kombination beider Signalformenbestehen.

Einem Zwischenkreisumrichter mit einem eingangsseitig über ein Laderelais mit einem speisenden Wechsel- oder Drehstromnetz verbundenen Ladegleichrichter, einem über einen Ladewiderstand oder eine Konstantstromquelle mit dem Ladegleichrichter verbundenen Zwischenkreiskondensator kann ein erster Eingang des Komparators über einen Spannungsteiler sowohl mit dem negativen Potentialanschluss des Zwischenkreiskondensators als auch über einen Ladewiderstand und eine Diodenschaltung mit dem speisenden Wechsel- oder Drehstromnetz verbunden werden und der zweiter Eingang mit einer Referenzspannung beaufschlagt werden.

Eine negative oder positive Prüfspannung kann als Gleichspannungsüberlagerung zur Erdschlusserkennung durch eine kathodenseitig oder anodenseitig mit dem speisenden Wechsel- oder Drehstromnetz verbundene Diodenschaltung erzeugt und an den einen Eingang des Komparators angelegt werden, während am zweiten Eingang des Komparators eine negative bzw. positive Referenzspannung anliegt.

Alternativ zur Bildung einer negativen oder positiven Prüfspannung für eine Erdschlusserkennung durch Gleichspannungsüberlagerung kann auch eine Wechselspannung als Prüfspannung für eine Erdschlusserkennung durch Wechselspannungsüberlagerung vorgesehen werden. In dieser Ausführungsform wird der erste Eingang des Komparators über einen Spannungsteiler an die Kathode einer Diode angeschlossen, deren Anode mit dem negativen Potentialanschluss des Zwischenkreiskondensators und über einen Widerstand mit dem speisenden Wechsel- oder Drehstromnetz verbunden ist, und der zweite Komparatoreingang mit einer positiven Referenzspannung beaufschlagt, wobei parallel zu dem mit Masse- oder Erdpotential verbundenen einen Widerstand des Spannungsteilers ein Kondensator geschaltet ist.

Das erfindungsgemäße Verfahren eignet sich in besonderer Weise für die Erkennung eines Erdschlusses in einer oder mehreren Phasen bei einer Vielzahl von an einen Stromrichter-Zwischenkreis angeschlossenen Leistungsteilen, insbesondere von Wechsel- und Drehstrommotoren, da das erfindungsgemäße Verfahren alle Phasen der Lastanschlüsse gleichzeitig auf Erdschluss überprüft, ohne dass eine der Lastphasen bestromt werden muss.

Anhand von in der Zeichnung dargestellten Ausführungsbeispielen soll der der Erfindung zugrundeliegende Gedanke näher erläutert werden. Es zeigen:
- Fig. 1 -: eine Schaltung zur Erdschlussüberwachung eines Zwischenkreisumrichters mit einer Erdschlusserkennungsschaltung durch negative Gleichspannungsüberlagerung;
- Fig. 2 -: eine Schaltung wie in Figur 1 mit einer Erdschlusserkennungsschaltung durch positive Gleichspannungsüberlagerung und
- Fig. 3 -: eine Schaltung wie in den Figuren 1 und 2 mit einer Erdschlusserkennungsschaltung durch Wechselspannunngsüberlagerung.

Figur 1 zeigt einen an ein speisendes Drehstromnetz 1 über ein Laderelais 2 angeschlossenen Drehstrom-Zwischenkreisumrichter 3, 4, 5 zur Speisung eines Drehstrommotors 7 mit den Phasen R, S, T wie er vorstehend zur Erläuterung des der Erfindung zugrundeliegenden Problems anhand der Figur 1 beschrieben wurde.

Die umrahmte Erdschlusserkennungsschaltung setzt sich aus einer Diodenschaltung 9 zur Erzeugung einer Prüfspannung, einem Komparator 8, einem Spannungsteiler 11, 12 und einem Referenzspannungsanschluss 13 zusammen. Die in dem Ausführungsbeispiel gemäß Figur 1 negative Prüfspannung wird mittels der Diodenschaltung 9 erzeugt, die drei kathodenseitig an die Phasen L1, L2, L3 des speisenden Drehstromnetzes1 angeschlossene Dioden, 91, 92, 93 umfasst. Die miteinander verbundenen Anoden der Dioden 91, 92, 93 sind über einen hochohmigen Widerstand 10 mit dem negativen Anschluss -UZ des Zwischenkreiskondensators 40 verbunden, der gleichzeitig der Anschlusspunkt eines Spannungsteilers ist, der aus zwei in Reihe geschalteten Widerständen 11, 12 gebildet wird.

Der Spannungsteiler 11, 12 ist mit Masse- oder Erdpotential und die Verbindung der beiden Spannungsteilerwiderstände11, 12 mit einem ersten Eingang E1 des Komparators 8 verbunden. An den zweiten Eingang E2 des Komparators 8 ist eine Referenzspannung -Uref von beispielsweise -5V angelegt. Der Ausgang des Komparators 8 ist mit einer nicht näher dar gestellten Auslöseeinrichtung, beispielsweise einer Steuerschaltung für das Laderelais 2 und/oder einer Anzeigeeinrichtung verbunden.

Nachstehend soll die Funktion der Erdschlusserkennungsschaltung gemäß Figur 1 näher erläutert werden.

Die Dioden 91, 92, 93 der Diodenschaltung 9 legen die negativen Halbwellen der Versorgungsspannung des speisenden Drehstromnetzes 1 über den hochohmigen Widerstand 10 an den negativen Anschluss -UZ des Zwischenkreiskondensators 40. Dadurch wird ein Stromfluss von wenigen Milliampere hervorgerufen, der aber das Potential des negativen Anschlusses -UZ des Zwischenkreiskondensators 40 auf negativere Werte ziehen muss, wenn kein Erdschluss vorliegt. Im Idealfall beträgt das Potential des negativen Anschlusses -UZ des Zwischenkreiskondensators 40 bei Anlegen der Prüfspannung -280 V. Aus schaltungstechnischen Gründen liegt die Spannung am negativen Anschluss -UZ des Zwischenkreiskondensators 40 auch bei nicht vorhandenem Erdschluss in einer der Phasen R, S, T des Drehstrommotors 7 jedoch darunter, so dass beispielsweise als Kriterium vorgegeben werden kann, dass bei einem Potential am negativen Anschluss des -UZ des Zwischenkreiskondensators 40 von etwa -50 V oder darunter kein Erdschluss vorliegt.

Mit Hilfe des aus den Spannungsteilerwiderständen 11, 12 gebildeten Spannungsteilers wird die am ersten Eingang E1 des Komparators 8 anliegende Spannung um den Faktor 10 verkleinert und mit der am zweiten Eingang E2 des Komparators 8 anliegenden Referenzspannung -Uref von beispielsweise - 5V verglichen. Liegt am ersten Eingang E1 des Komparators 8 ein niedrigeres Potential an als an seinem zweiten Eingang E2, gibt der Komparator 8 ein Freigabesignal an das Laderelais 2 ab.

Liegt dagegen ein Erdschluss in einer der drei Phasen R, S, T am Ausgang des Zwischenkreisumrichters 3, 4, 5 vor, so kann der negative Anschluss -UZ des Zwischenkreiskondensators 40 der negativen Prüfspannung nicht folgen, d.h. auf ein negatives Potential gehen, da über die Freilaufdiode 65 im Falle eines Erdschlusses in der Phase T und im Einschaltzeitpunkt noch ungeladenem Zwischenkreiskondensator 40 nicht mehr als die Diodenspannung abfallen kann, so dass das Schaltkriterium von beispielsweise -50 V nicht zu erreichen ist, solange der Zwischenkreiskondensator 40 ungeladen ist. In diesem Fall gibt der Komparator 8 ein entsprechendes Signal an die Auslöseeinrichtung, beispielsweise ein Sperrsignal an das Laderelais 2 sowie gegebenenfalls ein Signal an eine optische und/oder akustische Anzeigeeinrichtung ab.

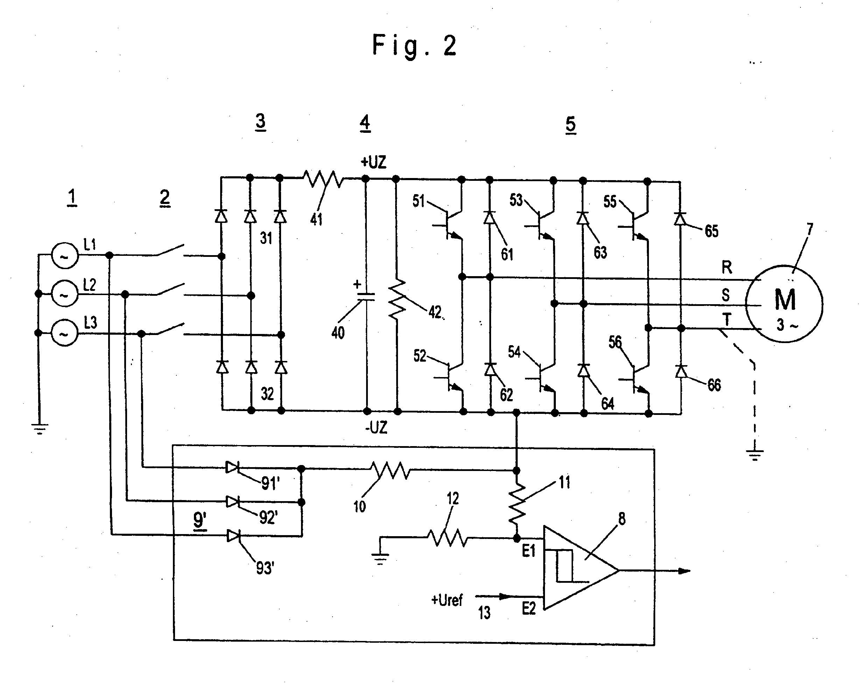

In der Schaltung gemäß Figur 2 wird in der Erdschlusserkennungsschaltung eine positive Prüfspannung erzeugt und dementsprechend der negative Anschluss -UZ des Zwischenkreiskondensators 40 auf positives Potential gezogen. Dies wird durch Umdrehen der Anschlüsse der Diodenschaltung 9 erzeugt, d.h. die modifizierte Diodenschaltung 9' weist drei anodenseitig an die Phasen L1, L2, L3 des speisenden Drehstromnetzes 1 angeschlossene Dioden 91', 92', 93' auf, deren Kathoden über den hochohmigen Widerstand 10 mit dem negativen Anschluss -UZ des Zwischenkreiskondensators 40 verbunden sind.

In dieser Ausführungsform funktioniert die Erdschlusserkennung auch bei geladenem Zwischenkreiskondensator 40, da bei positivem Potential am negativen Anschluss -UZ des Zwischenkreiskondensators 40 die Freilaufdiode 66 (im Falle eines Erdschlusses in der Phase T) leitet und erneut nur die Diodenspannung der Freilaufdiode 66 zu erreichen ist.
Nachteilig an dieser Ausführungsform einer Erdschlusserkennungsschaltung ist, dass am hochohmigen Widerstand 10 eine Spannung von ca. 560 V anliegt (-280 V vom negativen Anschluss -UZ des Zwischenkreiskondensators 40 und +280 V von der positiven Prüfspannung, d.h. der Spannung an den Anoden der Dioden 91', 92', 93'), so dass der hochohmige Widerstand 10 ständig Energie verbraucht. Beträgt das Potential auf beiden Seiten des hochohmigen Widerstands 10 jedoch beispielsweise -280 V, so liegt am hochohmigen Widerstand 10 keine Spannung an, so dass in diesem Falle keine Energie verbraucht wird.

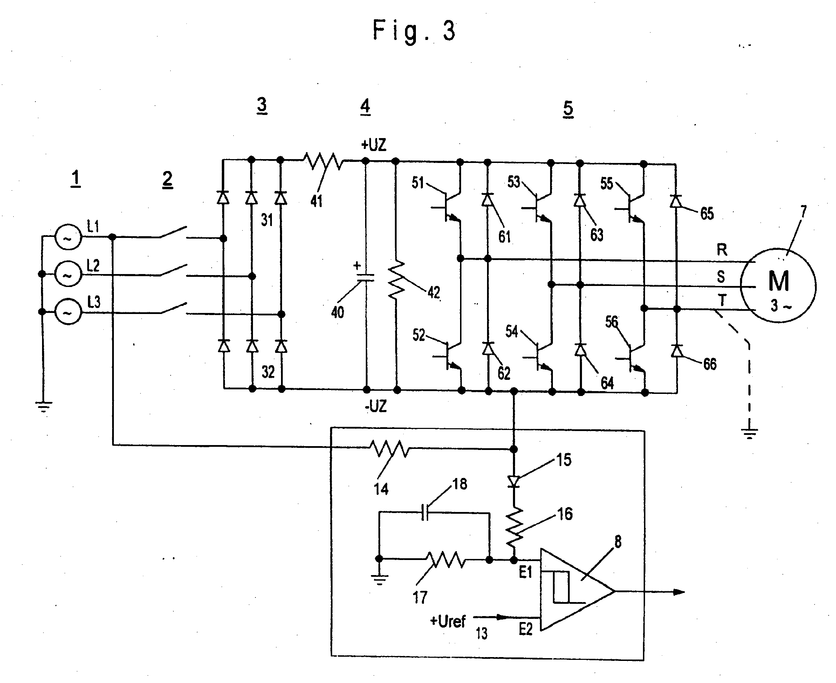

In einer weiter vereinfachten Erdschlusserkennungsschaltung gemäß Figur 3 entfällt die Diodenschaltung 9. Über einen unmittelbar an die eine Phase L1 des speisenden Drehstromnetzes 1 angeschlossenen Widerstand 14 wird eine Wechselspannung an den negativen Anschluss -UZ des Zwischenkreiskondensators 40 angelegt. Über eine anodenseitig mit dem negativen Anschluss -UZ des Zwischenkreiskondensators40 verbundene Diode 15 wird der positive Anteil des resultierenden Wechselspannungspotentials selektiert und über einen aus zwei Spannungsteilerwiderständen 16, 17 gebildeten Spannungsteiler an den ersten Eingang E1 des Komparators 8 angelegt.

Ein parallel zum zweiten Spannungsteilerwiderstand 17 geschalteter Kondensator 18 dient in dieser Schaltung zum Glätten des an den ersten Eingang E1 des Komparators 8 angelegten Signals.

Eine an den zweiten Eingang E2 des Komparators 8 angelegte Referenzspannung 13 dient wie in den voranstehend beschriebenen Ausführungsbeispielen als Kriterium zur Abgabe eines Freischalt- oder Sperrsignals vom Komparator 8 der Erdschlusserkennungsschaltung an das Laderelais 2 bzw. eines Signals an eine nachgeschaltete Anzeigeeinrichtung.

## Patentansprüche

1. Verfahren zur Erdschlussübervvachung bei der Ansteuerung eines Zwischenkreisumrichters (3, 4, 5), der eingangsseitig über ein Laderelais (2) mit einem speisenden Wechsel- oder Drehstromnetz (1) und ausgangsseitig mit einem oder mehreren elektromotorischen Antrieb(en) (7) verbunden ist, und in dessen Zwischenkreis (4) ein zwischen ein positives (+Uz) und negatives Potential (-Uz) des Zwischenkreises (4) geschalteter Zwischenkreiskondensator (40) angeordnet ist, der die Zwischenkreisenergie speichert und der über einen Ladewiderstand oder eine Konstantstromquelle (41) gespeist wird, **dadurch gekennzeichnet, dass** ein negativer Anschluss (-UZ) des Zwischenkreiskondensators (40) mit einer Prüfspannung beaufschlagt wird, und dass bei einer vorgegebenen Veränderung des Potentials des negativen Anschlusses (-UZ) des Zwischenkreiskondensators (40) gegenüber Masse- oder Erdpotential das Laderelais (2) geschlossen wird, wobei als Prüfspannung entweder über einen hochohmigen Widerstand (10, 14) angelegte negative oder positive Halbwellen des speisenden Wechsel- oder Drehstromnetzes (1), oder eine über den hochohmigen Widerstand (10, 14) angelegte Wechselspannung einer Phase (L1) des speisenden Wechsel- oder Drehstromnetzes (1) dient.

2. Verfahren nach Anspruch 1, **dadurch gekennzeichnet, dass** eine negative Prüfspannung an den negativen Anschluss (-UZ) des Zwischenkreiskondensators (40) angelegt und dessen Potential mit einem Referenzpotential (Uref) verglichen wird, und dass das Laderelais (2) geschlossen wird, wenn das Potential des negativen Anschlusses (-UZ) des Zwischenkreiskondensators (40) das Referenzpotential (Uref) erreicht oder unterschreitet.

3. Verfahren nach Anspruch 1, **dadurch gekennzeichnet, dass** eine positive Prüfspannung an den negativen Anschluss (-UZ) des Zwischenkreiskondensators (40) angelegt und dessen Potential mit einem Referenzpotential (Uref) verglichen wird und dass das Laderelais (2) geschlossen wird, wenn das Potential des negativen Anschlusses (-UZ) des Zwischenkreiskondensators (40) das Referenzpotential (Uref) erreicht oder überschreitet.

## Claims

1. Method for monitoring earth faults when controlling an intermediate circuit converter (3, 4, 5) which is connected, on the input side, to a feeding AC or three-phase system (1) via a charging relay (2) and is connected, on the output side, to one or more electromotive drive(s) (7) and in the intermediate circuit (4) of which is arranged an intermediate circuit capacitor (40) which is connected between a positive potential (+Uz) and a negative potential (-Uz) of the intermediate circuit (4), stores the intermediate circuit energy and is fed via a charging resistor or a constant current source (41), **characterized in that** a test voltage is applied to a negative connection (-UZ) of the intermediate circuit capacitor (40), and **in that** the charging relay (2) is closed in the event of a predefined change in the potential of the negative connection (-UZ) of the intermediate circuit capacitor (40) with respect to frame or earth potential, either negative or positive half-waves of the feeding AC or three-phase system (1) which are applied via a high-value resistor (10, 14) or an AC voltage of a phase (L1) of the feeding AC or three-phase system (1) which is applied via the high-value resistor (10, 14) being used as the test voltage.

2. Method according to Claim 1, **characterized in that** a negative test voltage is applied to the negative connection (-UZ) of the intermediate circuit capacitor (40) and its potential is compared with a reference potential (Uref), and **in that** the charging relay (2) is closed if the potential of the negative connection (-UZ) of the intermediate circuit capacitor (40) reaches or undershoots the reference potential (Uref).

3. Method according to Claim 1, **characterized in that** a positive test voltage is applied to the negative connection (-UZ) of the intermediate circuit capacitor (40) and its potential is compared with a reference potential (Uref), and **in that** the charging relay (2) is closed if the potential of the negative connection (-UZ) of the intermediate circuit capacitor (40) reaches or exceeds the reference potential (Uref).

## Revendications

1. Procédé de surveillance de la mise à la terre lors de la commande d'un convertisseur de circuit intermédiaire (3, 4, 5) dont l'entrée est reliée par le biais d'un relais de charge (2) avec un réseau d'alimentation à courant alternatif ou triphasé (1) et dont la sortie est reliée avec un ou plusieurs mécanismes d'entraînement (7) électromotorisés, et dans le circuit intermédiaire (4) duquel est disposé un condensateur de circuit intermédiaire (40) branché entre un potentiel positif (+UZ) et un potentiel négatif (-UZ) du circuit intermédiaire (4), lequel accumule l'énergie du circuit intermédiaire et est alimenté par le biais d'une résistance de charge ou d'une source de courant constant (41), **caractérisé en ce qu'**une tension de contrôle est appliquée à une borne négative (-UZ) du condensateur de circuit intermédiaire (40) et **en ce qu'**en présence d'une modification prédéfinie du potentiel de la borne négative (-UZ) du condensateur de circuit intermédiaire (40) par rapport au potentiel de masse ou de terre, le relais de charge (2) est fermé, la tension de contrôle étant soit des demi-ondes négatives ou positives du réseau d'alimentation à courant alternatif ou triphasé (1) appliquées par le biais d'une résistance (10, 14) à forte valeur ohmique, soit une tension alternative d'une phase (L1) du réseau d'alimentation à courant alternatif ou triphasé (1) appliquée par le biais de la résistance (10, 14) à forte valeur ohmique.

2. Procédé selon la revendication 1, **caractérisé en ce qu'**une tension de contrôle négative est appliquée à la borne négative (-UZ) du condensateur de circuit intermédiaire (40) et son potentiel est comparé avec un potentiel de référence (Uref), et **en ce que** le relais de charge (2) est fermé lorsque le potentiel de la borne négative (-UZ) du condensateur de circuit intermédiaire (40) devient égal ou inférieur au potentiel de référence (Uref).

3. Procédé selon la revendication 1, **caractérisé en ce qu'**une tension de contrôle positive est appliquée à la borne négative (-UZ) du condensateur de circuit intermédiaire (40) et son potentiel est comparé avec un potentiel de référence (Uref), et **en ce que** le relais de charge (2) est fermé lorsque le potentiel de la borne négative (-UZ) du condensateur de circuit intermédiaire (40) devient égal ou supérieur au potentiel de référence (Uref).
